# EUROPÄISCHE PATENTSCHRIFT

(11) **EP 3 983 581 B1**
(45) Veröffentlichungstag und Bekanntmachung des Hinweises auf die Patenterteilung: **01.05.2024**
(21) Anmeldenummer: 20730021.1
(22) Anmeldetag: 02.06.2020
(51) Int. Cl.: C30B 15/20, C30B 29/06, C30B 35/00

(54) **VERFAHREN ZUR HERSTELLUNG VON HALBLEITERSCHEIBEN AUS SILIZIUM**
METHOD FOR PRODUCING SEMICONDUCTOR WAFERS FROM SILICON
PROCÉDÉ POUR LA FABRICATION DE DISQUES SEMI-CONDUCTEURS EN SILICIUM

(30) Priorität: 14.06.2019 DE 102019208670
(43) Veröffentlichungstag der Anmeldung: 20.04.2022
(73) Patentinhaber: Siltronic AG, 81677 München (DE)
(72) Erfinder: BALANETSKYY, Sergiy, 09599 Freiberg (DE); DANIEL, Matthias, 09599 Freiberg (DE)
(86) Internationale Anmeldenummer: PCT/EP2020/065179
(87) Internationale Veröffentlichungsnummer: WO 2020/249422

(56) Entgegenhaltungen:
- EP-A1- 1 808 514
- EP-A1- 2 824 222
- EP-A2- 0 787 836
- EP-A2- 1 553 214
- DE-A1-102010 007 460

## Beschreibung

Gegenstand der Erfindung ist ein Verfahren zur Herstellung von Halbleiterscheiben aus Silizium, umfassend das Aufschmelzen von Polysilicium in einem Tiegel, Ziehen eines Einkristalls an einem Impfkristall aus einer in einem Tiegel erhitzten Schmelze nach Czochralski und das Abtrennen der Halbleiterscheiben vom gezogenen Einkristall.

Der Tiegel besteht üblicherweise aus einem Siliziumdioxid enthaltenden Material wie Quarz. Er wird in der Regel mit Bruchstücken und/oder mit Granulat aus polykristallinem Silizium gefüllt, das mit Hilfe eines um den Tiegel herum angeordneten Seitenheizers und eines unter dem Tiegel angeordneten Bodenheizers geschmolzen wird. Nach einer Phase der thermischen Stabilisierung der Schmelze wird ein einkristalliner Impfkristall in die Schmelze getaucht und angehoben. Dabei kristallisiert Silizium am von der Schmelze benetzten Ende des Impfkristalls. Die Kristallisationsgeschwindigkeit wird im Wesentlichen durch die Geschwindigkeit beeinflusst, mit der der Impfkristall angehoben wird (Kristallhubgeschwindigkeit) und von der Temperatur an der Grenzfläche, an der geschmolzenes Silizium kristallisiert. Durch geeignete Steuerung dieser Parameter wird zunächst ein als Dünnhals ("neck") bezeichneter Abschnitt gezogen, um Versetzungen zu beseitigen, dann ein konusförmiger Abschnitt des Einkristalls und schließlich ein zylindrischer Abschnitt des Einkristalls, von dem später die Halbleiterscheiben abgetrennt werden.

Wie beispielsweise in US-5954873 A beschrieben werden beim Kristallziehverfahren die entsprechenden Prozessparameter so eingestellt, dass eine radial homogene Defektverteilung im Kristall erreicht wird.

Insbesondere wird darauf geachtet, dass Agglomerate aus Leerstellen (Vakanzen), die auch COPs (crystal originated particles) genannt werden, nicht oder nur unter der Nachweisgrenze entstehen. Als Nachweisgrenze wird im Folgenden für COPs eine Dichte von 1000 Defekte/cm³ verstanden.

Gleichzeitig wird darauf geachtet, dass Agglomerate aus interstitiellen Siliziumatomen, die als LPITs benannt werden, nicht oder nur unter der Nachweisgrenze vorkommen. Als Nachweisgrenze wird im Folgenden eine Dichte von LPITs von 1 Defekt/cm² verstanden.

Dieses Halbleitermaterial wird im Folgenden als "defektfrei" bezeichnet.

Freiwerdende gasförmige Einschlüsse im Tiegelmaterial, Gas, das die Bruchstücke und/oder das Granulat umgibt, in der Schmelze entstehendes Siliziumoxid und Gas, das in die Schmelze diffundiert, gelten als mögliche Ursachen für das Entstehen von "Pinhole"-Defekte genannten Hohlräumen im Einkristall (nicht zu verwechseln mit COPs). Sie entstehen, wenn Gasbläschen zur Grenzfläche zwischen dem wachsenden Einkristall und der Schmelze gelangen und der Einkristall um sie herum kristallisiert. Schneiden die Trennebenen beim Abtrennen der Halbleiterscheiben die Hohlräume, haben die entstehenden Halbleiterscheiben kreisrunde Vertiefungen oder Löcher mit einem Durchmesser, der typischerweise einige Mikrometer bis einige Millimeter betragen kann. Halbleiterscheiben, in denen solche Hohlräume vorhanden sind, sind als Substratscheiben zur Herstellung von elektronischen Bauelementen unbrauchbar.

Gemessen kann die Konzentration der entstandenen Pinholes an Stabstücken beispielsweise mit Hilfe der Raster-Ultraschall-Methode werden, die zum Beispiel in DE 102 006032431 A1 beschrieben wurde, werden. Detektiert werden dabei Pinholes ab einem Durchmesser von etwa 50 µm. Das Bestimmen der jeweiligen genauen Größe der Pinholes ist mit diesem Verfahren mit größeren Messfehlern behaftet.

In US-9665931 A1 wird ein Verfahren beschrieben, wie die Konzentration und die jeweilige Größe von Pinholes an Halbleiterscheiben bestimmt werden kann. Mit diesem Verfahren kann die Größe der Pinholes sehr genau festgestellt werden.

Um die Größe von Pinholes in Stabstücken genau messen zu können, wird bevorzugt das zu vermessende Stabstück der Messung nach DE 102 006 032431 A1 unterzogen und dabei die Koordinaten der gefundenen Pinholes gespeichert.

Anschließend wird der Bereich, der entsprechende Pinholes enthält, bevorzugt in Halbleiterscheiben aufgeschnitten und mittels der in US-9665931 A1 beschriebenen Methode analysiert. Die Größe der so gefundenen Pinholes kann damit mit einer Messungenauigkeit von wenigen % bestimmt werden.

Die Erfinder haben erkannt, dass gerade defektfreies Halbleitermaterial eine verhältnismäßig hohe Konzentration an Pinholes des Durchmessers von größer als 50 µm enthält. Der Vermeidung von Pinholes mit einem Durchmesser von 50 µm und mehr gilt daher das Hauptinteresse.

Es wurden bereits eine Reihe von Vorschlägen veröffentlicht, wie die Bildung Pinholes unterdrückt werden kann. Viele dieser Vorschläge richten den Fokus auf die Verbesserung der Eigenschaften des Tiegelmaterials. Die Größe der entstehenden Pinholes bei Verwendung von ungeeignetem Tiegelmaterial ist kleiner als 50µm.

Auch gibt es Vorschläge (z.B.: EP 247 1980 A1), die das Einrichten des Tiegels optimieren, um so Verletzungen des Tiegels und somit das Entstehen von Gasblasen in der Schmelze und damit Pinholes im Einkristall vermeiden.

Andere Vorschläge konzentrieren sich auf die Unterdrückung oder Beseitigung von Pinholes während des Zeitraums des Schmelzens der Bruchstücke und/oder des Granulats. So wird beispielsweise in der US 2011/304081 A1 empfohlen, mittels geeigneter zeitlich veränderter Leistungsverteilung der verwendeten Heizer den Tiegel so zu schonen, dass die Dichte der auftretenden Pinholes im Kristall reduziert wird.

Um die gewünschten (Defekt-) Eigenschaften des gezogenen Kristalls zu erreichen, ist es notwendig, die Verteilung der Heizleistung entsprechend in festem Verhältnis einzustellen. Dies widerspricht zum Beispiel dem in DE10 339 792 A1 vorgeschlagenen Verfahren. Es ist damit unmöglich beide Ziele (niedrige Konzentration von Pinholes und gewünschte Defekteigenschaften) zu erreichen.

In der JP-5009097 A2 ist ein Verfahren zur Herstellung eines Einkristalls aus Silizium beschrieben, bei dem beim Aufschmelzen des Polysiliciums der Druck in der Kristallziehanlage auf einen Druck von 5 bis 60 mbar reduziert wird und beim Ziehen des Kristalls der Druck 100 mbar und mehr beträgt.

In der US 2011/214603 A1 wird eine Methode zur Herstellung eines Einkristalls aus Silicium beschrieben, bei der die Leistung der Heizer beim Aufschmelzen höher eingestellt wird als beim anschließenden Kristallziehen. Zusätzlich wird der Druck beim Aufschmelzen zu 30 mbar oder kleiner eingestellt, was kleiner ist als beim anschließenden Kristallziehen.

In der DE 10 2010 007460 A1 ist ein Verfahren zum Ziehen eines Einkristalls aus Silicium beschrieben, bei dem während des Ziehens die Gasströmung oberhalb der Schmelze optimiert wurde.

Die EP 2 824 222 A1 beschreibt ein Verfahren zur Herstellung von Halbleiterscheiben aus Silicium, umfassend das Schmelzen von Polysilicium in einem Tiegel und das Ziehen eines Einkristalls in einer Ziehanlage nach Czochralski, wobei die Ziehanlage während des Schmelzens des Polysiliciums mit einem Spülgas gespült wird.

Es zeigte sich aber, dass die beschriebenen Methoden Nachteile aufweisen. Insbesondere konnte festgestellt werden, dass die gezogenen Einkristalle erhöhte Verunreinigungswerte bezüglich Kohlenstoff und Eisen aufwiesen. Außerdem entsprach die aufgetretene hohe Dichte an großen Pinholes nicht den Erwartungen.

Die Erfinder haben erkannt, dass es mit den im Stand der Technik vorgeschlagenen Verfahren nicht möglich ist, Einkristalle nach Czochralski herzustellen, die sowohl eine sehr geringe Dichte großer Pinholes, als auch eine sehr niedrige Kontamination von Eisen und Kohlenstoff und dabei gleichzeitig die gewünschten Defekteigenschaften (defektfrei) aufweisen.

Die Aufgabe der Erfindung ist es, ein Verfahren zur Verfügung zu stellen, das es ermöglicht, einen defektfreien Kristall herzustellen, der sowohl eine minimale Konzentration von Pinholes mit einer Größe von mehr als 50 µm, als auch eine minimale Verunreinigung von Kohlenstoff und Eisen aufweist.

Die Aufgabe wird gelöst durch die in den Ansprüchen beschriebenen Verfahren.

### Kurzbeschreibung der Figuren

**Fig. 1** zeigt die Relation des Durchflusses f [l/h] des Inertgases als Funktion des Anlagendrucks p [mbar].
   Der Fachmann versteht unter der Einheit l/h (Liter pro Stunde) Normliter pro Stunde, also das Volumen pro Stunde, das das Gas beim Normaldruck haben würde.
**Fig. 2** zeigt einen typischen zeitlichen Verlauf der mit einer Kamera gemessenen Helligkeit beim Erhitzen des Siliciums in Helligkeitswerten b in jeweils relativen Einheiten.

Beim Aufheizen bleibt die gemessene Helligkeit im Rahmen der Fehlertoleranz zunächst konstant (201). Mit Einsetzen des Phasenübergangs fest zu flüssig steigt das Signal für die Helligkeit stark an (202).

Sobald das Silizium komplett geschmolzen ist, ist die gemessene Helligkeit wieder konstant (203), aber auf einem höheren Niveau als am Anfang (201).

Unter Schmelzen des Polysiliciums ist der Vorgang zu verstehen, bei dem Polysilicium von Raumtemperatur in festem Zustand auf eine Temperatur größer der Schmelztemperatur in flüssigem Zustand gebracht wird. Das Ende des Schmelzvorgangs ist definiert als der Zeitpunkt des Ansetzens des Impflings zum Kristallziehen. Danach beginnt das Kristallziehen.

In Tabelle 1 werden die Messergebnisse bzgl. der Konzentrationen von Pinholes, Kohlenstoff und Eisen der gezogenen Kristalle zusammengefasst, die sowohl nach dem Stand der Technik (Vergleichsbeispiel 1 und 2) als auch erfindungsgemäß (Beispiele 3,4 und 5) gezogen wurden.

### Detaillierte Beschreibung erfindungsgemäßer Ausführungsbeispiele

Es wurden Stäbe nach dem Czochralski-Verfahren sowohl mit einem nominellen Durchmesser von 300 mm als auch mit 200 mm gezogen. Dabei wurde polykristallines Silicium in im Stand der Technik bekannten Quarztiegel geschichtet und zum Kristallziehen zur Verfügung gestellt.

Beim Kristallziehen wurden Mittel eingesetzt, um defektfreie Kristalle herzustellen. Dies kann prinzipiell entweder mit einem CUSP Magnetfeld, einem horizontalen Magnetfeld oder mit einem magnetischen Wanderfeld erfolgen. Ferner werden hierfür die Kristalldrehung und Tiegeldrehung entsprechend eingestellt.

Die in Tabelle 1 gezeigten Ergebnisse stammen von Kristallen, die mit horizontalem Magnetfeld gezogen wurden. Die Kristall- und Tiegeldrehung wurden dabei so variiert, dass jeweils eine unterschiedliche Sauerstoffkonzentration erreicht wurde.

Für die weitere Beschreibung ist es unerheblich, welcher Magnetfeldtyp verwendet wird; essentiell ist, dass eine im Zentrum aufwärts gerichtete Schmelzenströmung erreicht wird, so dass ein defektfreier Kristall gezogen wird.

Jeder so gezogene monokristalline Stab wurde dabei mittels einer Bandsäge in Stabstücke zerteilt, entsprechend dem Stand der Technik in Wafer geschnitten und diese sowohl auf Pinholes, Defekteigenschaften als auch auf Verunreinigungen (Kohlenstoff, Eisen) hin untersucht.

Die Messung der Konzentration an Kohlenstoff in Silicium wurde mit Hilfe der Gasfusionsanalyse, die zum Beispiel beschrieben in DE 1020 14217514 A1 wurde, durchgeführt.

Die Eisenkonzentration wurde mit Hilfe der ICPMS (Inductively Coupled Plasma - **M**ass **S**pectrometry) Methode gemessen. Sie kann auch mit NAA (Neutronenaktivierungsanalyse) mit geeigneter Kalibrierung durchgeführt gemessen werden.

In Beispiel 1 der Tabelle 1 sind die Ergebnisse dargestellt, die mit herkömmlichen, aus dem Stand der Technik bekannten Mitteln erreichbar sind. Die Konzentration an Pinholes wurde dabei als zu hoch identifiziert.

Mit dem Zweck, die Konzentration von Pinholes im monokristalline Stab zu verringern, wurde von den Erfindern zunächst versucht, beim Schmelzen des Polysiliciums den Druck so weit zu reduzieren, dass -wie in JP-5009097 A2 beschrieben- die möglicherweise entstehenden Gase nicht Pinholes verursachen können. Die Erfinder haben dabei erkannt, dass diese Maßnahme nur bedingt geeignet ist, die Konzentration entsprechend zu reduzieren. Die Ergebnisse sind in Beispiel 2 der Tabelle 1 zusammengefasst.

Es zeigte sich, dass die Maßnahme eine offenbar zusätzliche erhöhte Kontamination der monokristallinen Stäbe mit Kohlenstoff und Eisen bewirkt (Tabelle 1: Beispiel 2).

Die Erfinder haben daher erkannt, dass zusätzliche Maßnahmen durchzuführen sind, um diese Probleme zu lösen.

Beim Einrichten des Tiegels wird darauf geachtet, dass bevorzugt Polysilicium mit sehr geringen Verunreinigungen verwendet wird, wie es zum Beispiel in DE 10 2010 040 293 A1 beschrieben wird.

Besonders bevorzugt wird Silicium mit einer mittleren massenbezogenen spezifischen Oberfläche von kleiner als 2 cm²/g verwendet.

Ganz besonders bevorzugt wird der Tiegel im Abstand kleiner als 5 cm und größer als 2 cm von der Tiegelwand mit Polysilicium mit einer massenspezifischen Oberfläche von kleiner als 1 cm²/g eingerichtet. Der Rest des Tiegelvolumens wird mit Polysilicium mit einer massenspezifischen Oberfläche von größer als 1 cm²/g und kleiner als 5 cm²/g eingerichtet.

Beim Schmelzen des Polysiliciums wird ein Druck in der Kristallziehanlage von bevorzugt nicht größer als 10 mbar eingestellt. Gleichzeitig wird bevorzugt der gesamte Durchfluss f eines Spülgases durch die Ziehanlage so eingestellt, dass er größer ist als der Durchfluss f [l/h] multipliziert mit 160.

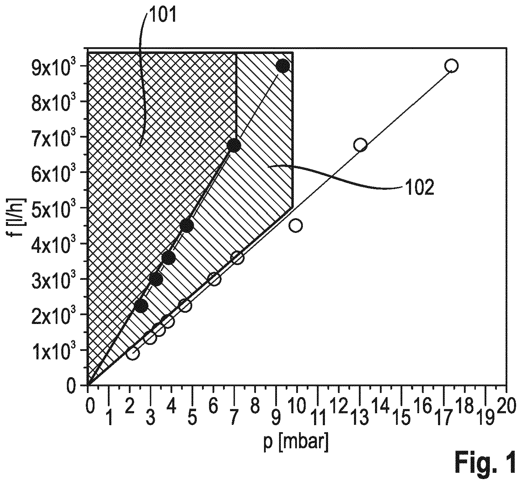

Figur 1 zeigt die bevorzugte Fläche aus Druck p und Durchfluss f in (102).

Besonders bevorzugt wird der gesamte Durchfluss eines Spülgases durch die Ziehanlage so eingestellt, dass er größer ist als der Durchfluss f [l/h] multipliziert mit 400 und ganz besonders bevorzugt 720. Dabei wird bevorzugt der Druck nicht größer als 10 mbar eingestellt.

Erfindungsgemäß gilt während des Schmelzens des Polysiliciums für den Durchfluss des Spülgases f und den Druck in der Ziehanlage p die Relation f [l/h] > 720 x Druck p [mbar] bei einem Druck p in der Ziehanlage von kleiner als 7 mbar.

Figur 1 zeigt die bevorzugte Fläche aus Druck p und Durchfluss f in (101).

Generell ist es vorteilhaft, den Durchfluss f möglichst hoch zu halten und gleichzeitig den Druck möglichst klein. Der maximale Durchfluss bei gegebenem Druck ist dabei lediglich von der Pumpleistung abhängig.

Das verwendete Spülgas beim Schmelzen umfasst Gase aus der Liste der Gase Argon, Helium, Stickstoff oder Kombinationen daraus. Bevorzugt wird Argon mit einem Reinheitsgrad von größer 99,99 Vol % verwendet.

In Beispiel 3 der Tabelle 1 sind die Ergebnisse von Kristallen dargestellt, die mit oben beschriebenen erfindungsgemäßen Mitteln erreicht wurden.

In einer weiteren Ausführungsform wurde der Druck (und damit auch der Durchfluss des Spülgases) erhöht, sobald das erste Polysilicium flüssig geworden ist. Die Druckerhöhung betrug dabei 4 mbar, bevorzugt 8 mbar, und ganz besonders bevorzugt 12 mbar.

Der Schmelzvorgang wurde dabei mit einer Kamera beobachtet, die mittels geeigneter Methoden der digitalen Bildverarbeitung den Zeitpunkt bestimmt, ab dem das erste Silicium flüssig geworden ist.

Die Erfinder haben erkannt, dass der Zeitpunkt, bei dem eine signifikante Erhöhung der Helligkeit der ausgewerteten Bilddaten festgestellt werden kann, sehr gut mit dem Zeitpunkt des Beginns des Phasenübergangs von Fest nach Flüssig zu korrelieren ist.

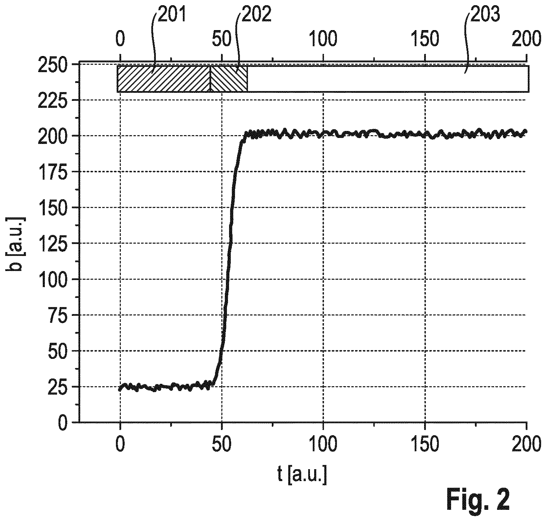

In Figur 2 wird zum Beispiel die Helligkeit als Funktion der Zeit dargestellt. Es zeigte sich, dass bevorzugt in dem Zeitpunkt zwischen den Bereichen (201) und (202) der Druck zu erhöhen ist, um eine weitere positive Wirkung hinsichtlich der Dichte von Pinholes und der Konzentration von Kohlenstoff und Eisen zu erreichen.

In Beispiel 4 der Tabelle 1 sind die Ergebnisse von Kristallen dargestellt, die mit oben beschriebenen erfindungsgemäßen Mitteln erreicht wurden.

In einer zusätzlichen Ausführungsform wurde beim Einrichten Polysilicium verwendet, das einen Chlorgehalt von 1 ppba hatte.

Die Erfinder haben dabei erkannt, dass überraschenderweise der Einsatz von Polysilicium mit einem Chlorgehalt von größer als 1 pbba weitere positive Auswirkungen auf die Kontamination mit Eisen hat, obwohl der Fachmann annehmen würde, dass Chlor bei hohen Temperaturen Eisen aus der Anlage freisetzen und das Silicium verunreinigen müsste.

In Beispiel 5 der Tabelle 1 sind die Ergebnisse von Kristallen dargestellt, die mit oben beschriebenen erfindungsgemäßen Mitteln erreicht wurden.

## Patentansprüche

1. Verfahren zur Herstellung von Halbleiterscheiben aus Silizium, umfassend
das Schmelzen von Polysilicium in einem Tiegel,
das Ziehen eines Einkristalls in einer Ziehanlage nach Czochralski;
das Teilen des Einkristalls in Kristallstücke und
das Schneiden der Kristallstücke in Halbleiterscheiben,
wobei die Ziehanlage mit einem Spülgas gespült wird, **dadurch gekennzeichnet, dass**
während des Schmelzens des Polysiliciums für den Durchfluss des Spülgases f und den Druck in der Ziehanlage p folgende Relation gilt Durchfluss f [l/h] > 720 x Druck p [mbar],
wobei der Druck p in der Ziehanlage kleiner ist als 7 mbar.

2. Verfahren nach Anspruch 1, **dadurch gekennzeichnet, dass** der Tiegel mit Polysilicon eingerichtet ist, das im Mittel eine massebezogene spezifische Oberfläche von kleiner als 2 cm²/g besitzt.

3. Verfahren nach einem der vorigen Ansprüche, **dadurch gekennzeichnet, dass** das eingesetzte Polysilicium einen Chlorgehalt von größer als 1 ppba besitzt.

## Claims

1. Method for producing silicon semiconductor wafers, comprising melting polysilicon in a crucible, pulling a single crystal in a Czochralski pulling system, dividing the single crystal into crystal pieces and cutting the crystal pieces into semiconductor wafers, the pulling system being purged with a purge gas, characterized in thatthe following relationship applies to the flow rate of the purge gas f and the pressure in the pulling system p during the melting of the polysilicon:flow rate f [l/h] > 720 x pressure p [mbar], wherein the pressure p in the pulling system is less than 7 mbar.

2. Method according to Claim 1, **characterized in that** the crucible is set up with polysilicon having, on average, a mass-based specific surface area of less than 2 cm²/g.

3. Method according to either of the preceding claims, characterized in thatthe polysilicon used has a chlorine content of greater than 1 ppba.

## Revendications

1. Procédé de fabrication de tranches semiconductrices en silicium, comprenant
la fusion de polysilicium dans un creuset,
le tirage d'un monocristal dans une installation de tirage selon Czochralski ;
la fragmentation du monocristal en morceaux de cristal et
la découpe des morceaux de cristal en tranches semiconductrices,
dans lequel l'installation de tirage est rincée avec un gaz de rinçage, **caractérisé en ce que**
pendant la fusion du polysilicium, on a entre le débit du gaz de rinçage f et la pression p dans l'installation de tirage la relation suivante débit f [l/h] > 720 x pression p [mbar],
la pression p dans l'installation de tirage étant inférieure à 7 mbar.

2. Procédé selon la revendication 1, **caractérisé en ce que** le creuset est pourvu d'un polysilicium qui en moyenne présente une aire massique spécifique inférieure à 2 cm²/g.

3. Procédé selon l'une des revendications précédentes, **caractérisé en ce que** le polysilicium utilisé présente une teneur en chlore supérieure à 1 ppba.
